# EUROPEAN PATENT SPECIFICATION

(11) **EP 2 803 120 B1**
(45) Date of publication and mention of the grant of the patent: **12.05.2021**
(21) Application number: 13736101.0
(22) Date of filing: 09.01.2013
(51) Int. Cl.: G02F 1/35, H01S 3/067, H01S 3/00, H01S 3/10, H01S 3/13, H01S 3/109, H01S 3/23, H01S 5/0687

(54) **SINGLE MODE SINGLE FREQUENCY LASER SYSTEM WITH HARMONIC GENERATION**
MONOMODALES MONOFREQUENTES LASERSYSTEM MIT OBERWELLENERZEUGUNG
SYSTÈME LASER MONOMODE, MONOFRÉQUENCE À GÉNÉRATION D'HARMONIQUES

(30) Priority: 09.01.2012 US 201261584395 P
(43) Date of publication of application: 19.11.2014
(73) Proprietor: IPG Photonics Corporation, Oxford, Massachusetts 01540 (US)
(72) Inventor: GAPONTSEV, Valentin, Worchester, MA 01609 (US); AVDOKHIN, Alexey, Brooklin, MA 02445 (US); ANDRUSYAK, Oleksiy, Boston, MA 02135 (US); GRAPOV, Yuri, Sutton, MA 01590 (US)
(74) Representative: Kohlmann, Kai
(86) International application number: PCT/US2013/020866
(87) International publication number: WO 2013/106456

(56) References cited:
- JP-A- H06 283 786
- JP-A- 2002 062 555
- JP-A- 2007 003 616
- US-A1- 2009 010 288
- US-A1- 2009 010 288
- US-A1- 2009 059 968
- US-A1- 2010 085 632
- US-A1- 2010 166 026
- US-A1- 2011 026 102
- SHADDOCK D A ET AL: "Modulation-free control of a continuous-wave second-harmonic generator; Modulation-free control of a continuous-wave second-harmonic generator", JOURNAL OF OPTICS. A, PURE AND APPLIED OPTICS, INSTITUTE OF PHYSICS PUBLISHING, BRISTOL, GB, vol. 2, no. 5, 1 September 2000 (2000-09-01), pages 400-404, XP020080664, ISSN: 1464-4258, DOI: 10.1088/1464-4258/2/5/309
- MASAHIKO TANI ET AL: "Generation of terahertz radiation by photomixing with dual- and multiple-mode lasers; Generation of terahertz radiation by photomixing with dual- and multiple-mode lasers", SEMICONDUCTOR SCIENCE AND TECHNOLOGY, IOP PUBLISHING LTD, GB, vol. 20, no. 7, 1 July 2005 (2005-07-01), pages S151-S163, XP020086536, ISSN: 0268-1242, DOI: 10.1088/0268-1242/20/7/005
- ERIC D. BLACK: "An introduction to Pound-Drever-Hall laser frequency stabilization", AMERICAN JOURNAL OF PHYSICS, vol. 69, no. 1, 1 January 2001 (2001-01-01), page 79, XP055144240, ISSN: 0002-9505, DOI: 10.1119/1.1286663
- DREVER R W P ET AL: "LASER PHASE AND FREQUENCY STABILIZATION USING AN OPTICAL RESONATOR", APPLIED PHYSICS B. PHOTOPHYSICS AND CHEMISTRY, SPRINGER VERLAG. HEIDELBERG, DE, vol. B31, no. 2, 1 June 1983 (1983-06-01), pages 97-105, XP000710689, DOI: 10.1007/BF00702605

## Description

### BACKGROUND OF THE DISCLOSURE

### 1. Field of the disclosure

### Field of the Invention

This disclosure relates to a single mode, single frequency laser system, especially to a high power, high efficiency laser system which is configured to convert an input light to the desired frequency different from the input signal frequency via harmonic generation and other nonlinear processes.

### Prior Art Discussion

Fiber lasers including, for example, Yb-doped fiber lasers are very stable and efficient sources of high-power radiation. However, there are many important applications that require wavelengths outside of amplification bands of standard fiber lasers. These applications require light sources with high quality diffraction-limited single mode ("SM") beams operating in a continuous wave ("CW") or pulsed regime. For example, high-power CW green laser sources are used in a variety of applications, ranging from scientific (pumping of titanium-sapphire and dye lasers, cooling and trapping of atoms), to industrial (material processing, solar cell manufacturing, semiconductor industry, hologram production) to defense and security (LIDAR, dazzling, underwater communications).

Light sources capable of emitting high power, SM output at non-standard wavelengths can be realized using non-linear frequency conversion techniques, in which the light emitted by a light source is converted into other frequencies. Alternatively, nonlinear crystals can be configured to mix different input frequencies to obtain a third frequency which is either the sum or the difference of the input frequencies.

Many applications requiring wavelengths in the visible green range have traditionally utilized very inefficient and bulky 514-nm argon-ion lasers. As diode-pumped solid-state laser (DPSSL) technology is becoming more affordable, argon-ion lasers are rivaled by far more efficient and compact frequency-doubled DPSSLs.

Two frequency-doubling approaches have been used to produce near-diffraction-limited CW green beams with several tens of watts of output power. One scheme involves a diode- pumped solid-state laser with an intra-cavity non-linear crystal that is configured for the second harmonic generation (SHG) of the fundamental near-IR laser radiation. Both bulk and fiber lasers with intra-cavity SHG have been reported, with output powers up to 62 W for bulk and 19 W for fiber. Power scaling of bulk lasers with intra-cavity SHG above several tens of watts of green output power is challenging due to thermal beam distortion in the laser crystal.

Another configuration includes a near-IR bulk or fiber laser and a stand-alone external resonator with a nonlinear crystal. Using this scheme, more than 20 W of green output power has been achieved with an external resonator pumped by a fiber laser and more than 130 W of green output power has been recently reported, using an external resonator pumped by a bulk near-IR laser. However, these powers do not adequately address the industrial needs and should be further increased.

Frequency conversion techniques that use external resonators with nonlinear crystals require that fundamental frequency of the laser and resonant frequency of the external cavity be stabilized to each other, in order to maintain high frequency conversion efficiency. One of the known techniques used to achieve such stabilization employs a well-known Pound-Drever-Hall control scheme that is used to adjust the frequency of the tunable fiber seed laser and keep it matched to the resonant frequency of the external resonator. According to this technique, adjustment of the fiber seed laser frequency is realized by introduction of thermal and/or piezoelectric elements into the fiber seed laser cavity. The main limitation of this technique is the low speed of fiber seed laser frequency adjustment that can be practically achieved. While thermal adjustment is an inherently slow process, mechanical cavity adjustment with piezoelectric elements can, in theory, achieve high speeds, sufficient for effective frequency stabilization of a fiber seed laser. However, practical implementation of this technique at sufficiently high speeds shows that impacts generated by mechanical stresses upon fibers during piezoelectric adjustment lead to instabilities in fiber seed laser operation, which result in significant fluctuations of optical properties of laser radiation (power, polarization, etc.) emitted from the fiber seed laser. These fluctuations lead to a number of undesired effects, including damage to amplifiers and poor stability of the frequency-converted output power, which makes laser systems utilizing this technique of fiber seed laser frequency control not very practical.
JP 2002 062555 A discloses a semiconductor laser seeding its output laser beam to a Nd:YAG non-planar monolithic ring type laser. An external resonant cavity into which the laser signal is coupled comprises a third mirror that is coupled to a positioning means. The position of the third mirror is continuously controlled so that the resonator length of the optical resonator always satisfies resonance conditions. The position means is driven based on an error signal which is detected by means of a control circuit. A frequency harmonic generator (FHG) with a nonlinear crystal is located at a Brewster angle within the external resonant cavity to avoid reflection losses
Additionally, US 2010/085632 A1 discloses a single mode, single frequency laser system comprising a mechanically-fixed external cavity including mirrors. The cavity is seeded by a tunable distributed-feedback fiber laser.

Furthermore, many applications require high-power high-beam-quality CW and pulsed laser sources with wavelengths in the UV range. Existing lasers emitting radiation in the UV range are generally bulky, expensive, and exhibit a very low efficiency. However, these wavelengths can also be accessed through harmonic generation and other nonlinear processes. Utilization of external resonators with nonlinear crystals for frequency conversion of existing high power lasers operating at standard wavelengths allows one to obtain highly efficient and compact laser sources of high-power UV radiation.

Therefore, a need exists for single-frequency single-mode high-power ("SFSMHP") CW laser systems that operate with high efficiency and emit radiation at desired nonstandard wavelengths.

Another need exists for SFSMHP CW laser systems that operate with high efficiency and emit linearly polarized radiation at desired nonstandard wavelengths.

Another need exists for SFSMHP CW laser systems that operate with high efficiency, emit radiation at desired nonstandard wavelengths and are configured with a diode seed laser and a tunable external resonator with a nonlinear crystal configured for frequency conversion.

A further need exists for SFSMHP CW laser systems that operate with high efficiency, emit radiation at desired nonstandard wavelengths and are configured with a frequency-tunable diode seed laser and an external resonator with a nonlinear crystal configured for frequency conversion.

### SUMMARY OF THE DISCLOSURE

The needs described above are addressed by single-frequency, single-mode laser systems according independent claim 1. The disclosed single-frequency, single-mode high-power CW laser systems exhibit high efficiency, emit several hundred watts of output power at desired nonstandard wavelengths, and can be easily scaled to kW-level output powers.

One aspect of the disclosure includes a scheme - not part of the invention, but useful to understand the invention - configured with a linearly polarized diode seed laser or another type of a seed source emitting a linearly polarized single-frequency, low- noise optical signal at a desired fixed wavelength. The scheme is further configured with a fiber amplifier based on polarization maintaining fibers and an external resonant cavity including a frequency conversion element such as nonlinear crystal. One of the mirrors comprising the external resonant cavity is installed on a piezo actuator configured to displace the mirror so as to adjust the optical length of the cavity. The cavity is adjusted in such manner that resonant frequency of the external cavity is stabilized to the frequency of the seed source. As a result, the system outputs a stable frequency converted signal at a desired wavelength.

Another aspect of the disclosure relates to an optical system according to the invention emitting a stable frequency converted signal at a desired wavelength. In contrast to the configuration disclosed immediately above and not belonging to the invention, this optical system includes, among others, a frequency-tunable diode seed laser and a fixed external resonant cavity with a frequency conversion element. The frequency of the diode seed laser is tuned by varying the diode driving current in such a manner that it remains stabilized to the resonant frequency of the external cavity.

A further aspect of the disclosure is associated with a single-mode single-frequency CW laser system which is configured with a single-frequency fiber laser seed source and an external frequency-converting resonator with tunable resonant frequency, which is stabilized to the frequency of the seed source.

Yet another aspect relates to a configuration of a single-frequency single-mode high- power CW laser system emitting a stable frequency converted signal at a desired wavelength. In particular, the system includes multiple cascaded fiber amplification stages and has a several hundred watts or even a kW-range output power. In order to prevent undesirable nonlinear effects in long delivery fibers, the disclosed laser system may include a separate laser head encasing a booster amplifying stage and an external frequency-converting resonator, whereas preamplifiers and other system components are located in a main housing. In this configuration a fiber between the booster stage and the external resonator is relatively short, which minimizes the nonlinear effects.

### BRIEF DESCRIPTION OF THE DRAWINGS

Features and advantages of the currently disclosed single-frequency single-mode high- power ("SFSMHP") CW laser system (further referred to as laser system) that operates with high efficiency and emits radiation at a desired nonstandard wavelength will become more readily apparent with the help of the following drawings, in which:
FIG. 1 is a general diagram of the disclosed laser systems.
FIG. 2 is a general schematic of the disclosed laser system configured in accordance with one aspect of the disclosure not belonging to the invention.
FIG. 3 is a general schematic of the disclosed laser system configured in accordance with another aspect of the disclosure not belonging to the invention.
FIG. 4 is a general schematic of the disclosed laser system configured in accordance with the invention.
FIG. 5 is a general schematic of the disclosed laser system configured in accordance with still another aspect of the disclosure not belonging to the invention.
FIG. 6 shows output power, electrical-to-optical efficiency, and SHG efficiency as a function of electrical power consumption for an exemplary laser system that uses schemes and methods described in the present disclosure.

### SPECIFIC DESCRIPTION

Reference will now be made in detail to several examples and embodiments of laser systems that are illustrated in the accompanying drawings. Wherever possible, same or similar reference numerals are used in the drawings and the description to refer to the same or like parts. The drawings are in a simplified form and are not to scale. The word "couple" and similar terms do not necessarily denote direct and immediate connections, but also include connections through intermediate elements or devices.

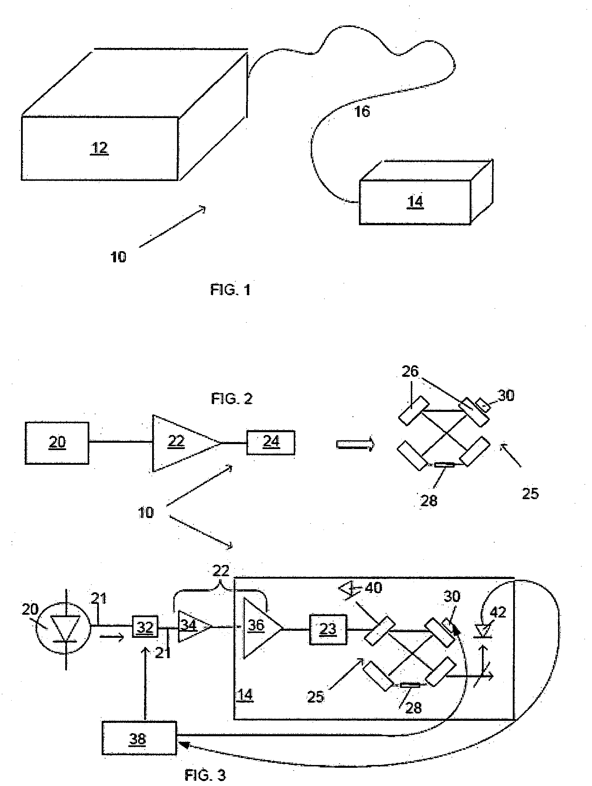

FIG. 1 shows a general diagram of a laser system 10 disclosed herein below in detail. The system 10 is configured with a main housing 12 encasing, among others, a seed source and preamplifier cascades. The system further includes a booster - most powerful and last fiber amplifying cascade. The multi-cascaded amplifying assembly is operative to amplify signal light with power in the mW range to hundreds of watts or to a kW level power. At such power levels, high intensity of light in fiber is associated with the presence of nonlinear effects which can be detrimental to stable operation of laser systems, in particular single-frequency, single-mode laser systems. System 10 may be configured with all of its components housed together or may include two separate housings, as shown in FIG. 1.

While the combination of the optical components placed in both housings may vary, system 10 is configured, for example, with a separate laser head 14 enclosing a booster amplification stage and an external frequency converting resonator disclosed herein below in detail. An optical fiber housed in delivery cable 16 guides the pre-amplified signal light of relatively low intensity to laser head 14. For these relatively low intensities, the occurrence of nonlinear effects is minimized. Inside the laser head 14, a fiber between the booster amplification stage and the external frequency converting resonator is relatively short. Alternatively, all the components including the booster amplifier may be placed in housing 12, except for the frequency converting resonator, which is housed separately in laser head 14.

FIG. 2 illustrates a general schematic of a laser system 10. The system includes a single-frequency linear y-polarized seed source 20 operating at a desired fundamental wavelength, for example at 1064 nm (signal light). The signal light is amplified by a single- or multi-stage fiber amplifier 22. The fiber amplifier and its diode pump lasers are configured to be highly-efficient, providing a MOPA configuration with high overall electrical-to-optical efficiency.

The output of the fiber amplifier 22 is coupled through a collimator 24 into an external frequency converting resonator 25, which may have different configurations and contain a different number of optical elements with two being minimal. As shown, the resonator 25 includes four mirrors 26 in a bow-tie configuration and a high-quality nonlinear crystal 28. While an LBO nonlinear crystal is customarily used for efficient second harmonic generation, other crystals used in the industry for frequency conversion purposes can be utilized as well. Due to the enhancement of input radiation intensity in the external resonator, frequency conversion efficiency over 90% can be achieved with proper resonator design. One of the resonator mirrors 26 is driven by a piezoelectric actuator ("PZT") 30 so that resonant frequency of the external resonator 25 is stabilized to the frequency of seed 20.

FIG. 3 illustrates one system 10, configured with a single- frequency linearly-polarized diode seed laser 20, which emits light signal at a desired wavelength. The semiconductor seed laser may be of any known configuration, including but not limited to distributed feedback lasers, quantum well lasers, vertical-cavity surface-emitting lasers, etc.

The signal light is coupled into a polarization-maintaining ("PM") passive fiber 21 guiding it to a phase modulator 32 after which the signal is further guided through another PM fiber also numbered 21 into amplifying unit 22. The latter may include one or more amplifying cascades 34, gradually increasing the signal light power, and a final booster amplifier 36 that amplifies the signal to the desired level.

The amplified signal light is coupled into the external resonator cavity 25 with a nonlinear crystal 28, which converts the wavelength (and frequency) of the amplified signal to a desired one, for example 532 nm. The frequency converted light is then coupled out of the resonator. Thus, laser system output is a CW single-frequency single-mode laser beam at a desired nonstandard wavelength.

In accordance with the disclosure, not belonging to the invention, a feedback control loop is configured to maintain resonant frequency of the external cavity 25 locked to the frequency of the seed laser 20. For example, a well-known Pound-Drever-Hall method of frequency stabilization can be used to control resonant frequency of the external cavity. The feedback loop includes a photo detector 42 configured to sample a small portion of the laser system output light. Alternatively, feedback signal can be derived from the light at the fundamental (seed laser) frequency that is not coupled into the cavity and is reflected from the input coupler of the external cavity (photo detector 40). The signal from photo detector 42 or 40 is coupled to a controller 38, where it is conditioned and processed to generate an error signal. This error signal is used to drive PZT 30, which actuates the respective mirror so as to alter the optical length of cavity 25 and keep the cavity resonant frequency locked to the frequency of the seed laser. Alternatively, other known frequency stabilization techniques can be used, for example, Hänsch-Couillaud method, etc.

Thus, in this disclosed laser system, the error signal produced by the feedback loop maintains cavity frequency locked to the frequency of the seed laser, without causing any disturbances to seed 20. The feedback system can be configured to have high speed and wide bandwidth response, such that the frequency-converted output of the laser system remains stable with very low optical noise even under harsh environmental conditions, like ambient temperature variations, mechanical vibrations, etc. This, of course, is very desirable for a number of applications that require a true continuous-wave low-noise laser source.

An optional isolator 23 may be placed between the booster 36 and the external resonator 25 in order to protect the amplification stages from any undesirable back-reflected power that may cause unstable amplifier operation.

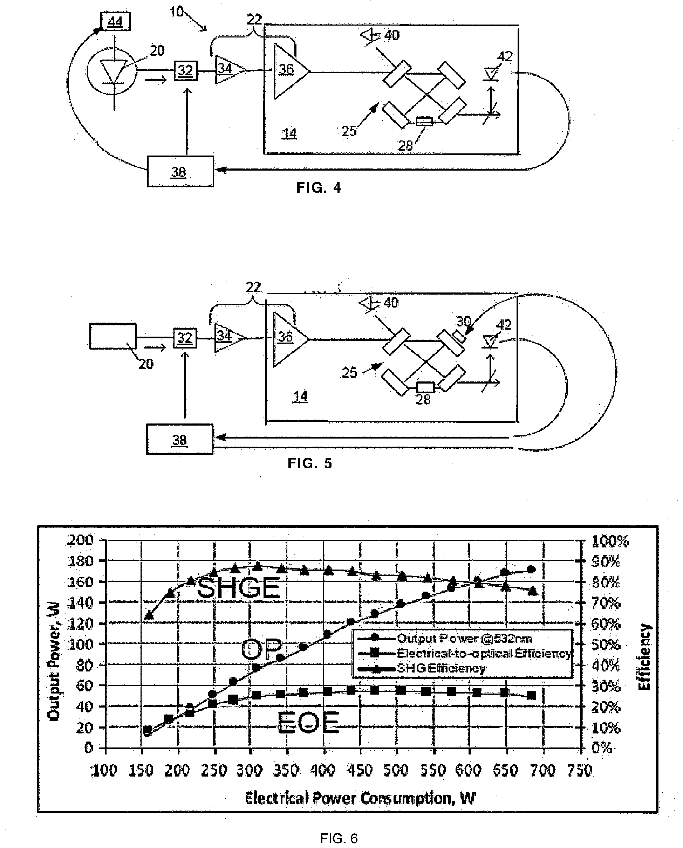

Referring to FIG. 4, an embodiment of system 10 according to the invention is realized by a scheme including a linearly-polarized single-frequency diode seed laser 20. However, in contrast to the previously disclosed laser-system of FIG.3, the diode seed source 20 is tunable. The rest of the laser system components include phase modulator 32, a multi-stage amplifying unit, external resonant cavity 25 and feedback loop with photodetector 42 or 40 and controller 38.

The frequency-tunable diode seed source 20 alters the control of the disclosed system in the following manner. In contrast to the previously disclosed laser-system, the signal light frequency is controlled in this scheme, not the optical length of external resonator 25. The error signal generated by controller 38 is directed to a diode driver 44, which is configured to vary the diode seed laser current according to the error signal. This variation of diode seed laser current results in respective variation of the emitted light frequency. Thus, a properly configured feedback loop controls the frequency of the diode seed laser and locks it to the resonant frequency of the mechanically-fixed external frequency-converting resonator. Similarly to the previously described laser-system, this laser system is resistant to various external stresses and produces a stable low-noise frequency-converted output beam, desired for many applications.

FIG. 5 illustrates still another configuration of laser system 10 not belonging to the invention. Similar to the laser-system of FIG. 3, linearly-polarized single-frequency seed source 20 is not frequency tuned. The resonance frequency of the external cavity is controlled and is locked to the frequency of the signal light emitted from seed 20. However, in contrast to the laser-system of FIG.3, seed source 20 is configured as a fiber laser, not a diode laser. The PZT 30 is used to vary the optical length of the external cavity 25 and is driven by the error signal from controller 38 in order to keep the resonant frequency of the external cavity locked to the frequency of the fiber seed laser. This laser system also carries the advantages of the previous laser-systems , discussed above.

FIG. 6 shows a summary of performance of an exemplary laser system that uses schemes and methods described in the present disclosure. The system featured a single- frequency seed laser with 1064 mn wavelength, a multi-stage fiber amplifier, and an external cavity resonator with LBO nonlinear crystal configured for second harmonic generation. The external frequency converting resonator in this system was optimized for 75W green power output, with SHG efficiency reaching about 90% at that power. Maximum green output power of the system was about 170 W. Overall electrical-to- optical efficiency of this exemplary system was between 25 and 30% for output powers over 75W.

The disclosed schemes can be easily modified for higher-order harmonics generation, sum and difference frequency mixing, and other nonlinear frequency conversion configurations, as readily realized by one of ordinary skills.

## Claims

1. A single-mode, single-frequency laser system (10), comprising:
- a frequency-tunable diode seed laser (20) configured to generate a linearly-polarized single-frequency seed laser signal at a fundamental frequency;
- an optical amplifier (22) configured to amplify the seed laser signal;
- two or more spaced mirrors (26) defining a mechanically-fixed external resonant cavity (25) , which is being configured to couple the amplified seed laser signal into the cavity;
- a diode seed laser driver (44) being configured to tune the frequency of the frequency-tunable diode seed laser (20) by varying the diode driving current to keep the frequency of the seed laser locked to the resonance frequency of the external cavity (25) in order to enhance the amplified seed laser signal coupled into the cavity (25); and
- a non-linear crystal (28) placed in a beam path inside the cavity (25), the cavity being configured to convert the frequency of the enhanced signal to a desired wavelength range.

2. The system of claim 1, wherein the seed laser (20) is being configured to operate in a continuous wave regime.

3. The system of claim 1, wherein the seed laser (20) is configured to be pulsed.

4. The system of claim 1, wherein the optical amplifier (22) is a polarization-maintaining single-mode fiber amplifier.

5. The system of claim 4 further comprises one or more fiber-pigtailed single-emitter diode lasers configured to pump the fiber amplifier (22).

6. The system of claim 1, wherein the optical amplifier is a bulk solid-state, semiconductor or disk amplifier.

7. The system of claim 1, wherein the optical amplifier (22) is configured with a single amplification stage.

8. The system of claim 1, wherein the optical amplifier (22) is configured with multiple amplification stages (34,36).

9. The system of claim 1 further comprising a photo-detector (42) configured to sample a portion of an output beam of the laser system (10) at the converted frequency, and a controller (38) configured to process the sampled signal, generate an error signal, and apply the error signal to vary pump current of the diode seed laser (20).

10. The system of claim 1 further comprising a photo-detector (40) configured to sample a portion of the laser signal reflected from an input mirror (26) of the external cavity (25), and a controller (38) configured to process the sampled signal, generate an error signal, and apply the error signal to vary pump current of the diode seed laser (20).

## Patentansprüche

1. Monomodales monofrequentes Lasersystem (10), umfassend:
- einen frequenzeinstellbaren Dioden-Seedlaser (20), der dazu ausgebildet ist, ein linear polarisiertes monofrequentes Seedlaser-Signal bei einer Grundfrequenz zu erzeugen;
- einen optischen Verstärker (22), der dazu ausgebildet ist, das Seedlaser-Signal zu verstärken;
- zwei oder mehr beabstandete Spiegel (26), die einen mechanisch fixierten, außenliegenden Resonanzhohlraum (25) definieren, der dazu ausgebildet ist, das verstärkte Seedlaser-Signal in den Hohlraum zu koppeln;
- einen Dioden-Seedlaser-Treiber (44), der dazu ausgebildet ist, die Frequenz des frequenzeinstellbaren Dioden-Seedlasers (20) einzustellen, indem der Diodenantriebsstrom variiert wird, um die Frequenz des Seedlasers an die Resonanzfrequenz des außenliegenden Hohlraums (25) gebunden zu halten, um das verstärkte Seedlaser-Signal, das in den Hohlraum (25) gekoppelt ist, zu verstärken; und
- einen nichtlinearen Kristall (28), der in einem Strahlpfad innerhalb des Hohlraums (25) platziert ist, wobei der Hohlraum dazu ausgebildet ist, die Frequenz des verstärkten Signals auf einen gewünschten Wellenlängenbereich umzuwandeln.

2. System nach Anspruch 1, wobei der Seedlaser (20) dazu ausgebildet ist, in einem fortlaufenden Wellenregime zu arbeiten.

3. System nach Anspruch 1, wobei der Seedlaser (20) dazu ausgebildet ist, gepulst zu sein.

4. System nach Anspruch 1, wobei der optische Verstärker (22) ein polarisationserhaltender monomodaler Faserverstärker ist.

5. System nach Anspruch 4, weiter umfassend einen oder mehrere faserangeschlossener Einzelemitter-Diodenlaser, die dazu ausgebildet sind, den Faserverstärker (22) zu pumpen.

6. System nach Anspruch 1, wobei der optische Verstärker ein Bulk-Festzustands-, Halbleiter- oder Scheibenverstärker ist.

7. System nach Anspruch 1, wobei der optische Verstärker (22) mit einer einzelnen Verstärkungsstufe ausgebildet ist.

8. System nach Anspruch 1, wobei der optische Verstärker (22) mit mehreren Verstärkungsstufen (34, 36) ausgebildet ist.

9. System nach Anspruch 1, weiter umfassend einen Fotodetektor (42), der dazu ausgebildet ist, einen Abschnitt eines Ausgangsstrahls des Lasersystems (10) bei der umgewandelten Frequenz abzutasten, und eine Steuerung (38), die dazu ausgebildet ist, das abgetastete Signal zu verarbeiten, ein Fehlersignal zu erzeugen und das Fehlersignal anzuwenden, um Pumpstrom des Dioden-Seedlasers (20) zu variieren.

10. System nach Anspruch 1, weiter umfassend einen Fotodetektor (40), der dazu ausgebildet ist, einen Abschnitt des Lasersignals abzutasten, der von einem Eingangsspiegel (26) des außenliegenden Hohlraums (25) reflektiert wird, und eine Steuerung (38), die dazu ausgebildet ist, das abgetastete Signal zu verarbeiten, ein Fehlersignal zu erzeugen und das Fehlersignal anzuwenden, um Pumpstrom des Dioden-Seedlasers (20) zu variieren.

## Revendications

1. Système laser monomode monofréquence (10), comprenant :
- un laser d'ensemencement à diode accordable en fréquence (20) configuré pour générer un signal laser d'ensemencement monofréquence polarisé linéairement à une fréquence fondamentale ;
- un amplificateur optique (22) configuré pour amplifier le signal laser d'ensemencement ;
- deux miroirs espacés (26) ou plus définissant une cavité résonnante externe fixée mécaniquement (25), qui est configurée pour coupler le signal laser d'ensemencement amplifié dans la cavité ;
- un circuit d'attaque laser d'ensemencement à diode (44) configuré pour accorder la fréquence du laser d'ensemencement à diode accordable en fréquence (20) en faisant varier le courant d'attaque de diode pour maintenir la fréquence du laser d'ensemencement verrouillée à la fréquence de résonnance de la cavité externe (25) afin d'améliorer le signal laser d'ensemencement amplifié couplé dans la cavité (25) ; et
- un cristal non linéaire (28) placé dans un trajet de faisceau à l'intérieur de la cavité (25), la cavité étant configurée pour convertir la fréquence du signal amélioré à une plage de longueur d'onde souhaitée.

2. Système selon la revendication 1, dans lequel le laser d'ensemencement (20) est configuré pour fonctionner dans un régime d'onde continue.

3. Système selon la revendication 1, dans lequel le laser d'ensemencement (20) est configuré pour être pulsé.

4. Système selon la revendication 1, dans lequel l'amplificateur optique (22) est un amplificateur à fibre monomode maintenant la polarisation.

5. Système selon la revendication 4, comprenant en outre un ou plusieurs lasers à diode à émetteur unique avec fibre amorce configurés pour pomper l'amplificateur à fibre (22).

6. Système selon la revendication 1, dans lequel l'amplificateur optique est un amplificateur intégré à état solide, à semi-conducteur ou à disque.

7. Système selon la revendication 1, dans lequel l'amplificateur optique (22) est configuré avec un étage d'amplification unique.

8. Système selon la revendication 1, dans lequel l'amplificateur optique (22) est configuré avec plusieurs étages d'amplification (34, 36).

9. Système selon la revendication 1, comprenant en outre un photodétecteur (42) configuré pour échantillonner une portion d'un faisceau de sortie du système laser (10) à la fréquence convertie, et un organe de commande (38) configuré pour traiter le signal échantillonné, générer un signal d'erreur, et appliquer le signal d'erreur pour faire varier le courant de pompe du laser d'ensemencement à diode (20) .

10. Système selon la revendication 1, comprenant en outre un photodétecteur (40) configuré pour échantillonner une portion du signal laser réfléchi depuis un miroir d'entrée (26) de la cavité externe (25), et un organe de commande (38) configuré pour traiter le signal échantillonné, générer un signal d'erreur, et appliquer le signal d'erreur pour faire varier le courant de pompe du laser d'ensemencement à diode (20) .
